(19) Europäisches Patentamt / European Patent Office / Office européen des brevets

(11) **EP 2 192 635 B1**

(12) **FASCICULE DE BREVET EUROPEEN**

(45) Date de publication et mention
de la délivrance du brevet:
**30.08.2017 Bulletin 2017/35**

(51) Int Cl.:
*H01L 51/56* (2006.01)  *H01L 51/52* (2006.01)
*H01L 51/00* (2006.01)

(21) Numéro de dépôt: **09176670.9**

(22) Date de dépôt: **20.11.2009**

(54) **Procédé de fabrication d'un substrat nanostructuré pour OLED et procédé de fabrication d'une OLED avec le substrat nanostructuré**

Herstellungsverfahren eines nanostrukturierten Substrats für eine OLED und Herstellungsverfahren einer OLED mit dem nanostrukturierten Substrat

Process of manufacturing a nanostructured substrate for an OLED and process of manufacturing an OLED with the nanostructured substrate

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **28.11.2008 FR 0858120**

(43) Date de publication de la demande:
**02.06.2010 Bulletin 2010/22**

(73) Titulaire: **Commissariat à l'Énergie Atomique et aux Énergies Alternatives
75015 Paris (FR)**

(72) Inventeurs:
• **Mary, Alexandre**
  **38360 Sassenage (FR)**
• **Andre, Luc**
  **38000 Grenoble (FR)**
• **Landis, Stefan**
  **38500 Voiron (FR)**

(74) Mandataire: **Augarde, Eric
Brevalex
56 Boulevard de l'Embouchure,
Bât. B
B.P. 27519
31075 Toulouse Cedex 2 (FR)**

(56) Documents cités:
**WO-A-2005/089028    US-A- 6 080 030
US-A1- 2007 292 986**

## Description

## DOMAINE TECHNIQUE

L'invention concerne un procédé de fabrication d'un substrat comprenant une surface nanostructurée pour une diode électroluminescente organique (« OLED » ou « Organic Light Emitting Diode » en anglais).

L'invention concerne, en outre, un procédé de fabrication d'une diode électroluminescente organique OLED comprenant une étape de fabrication d'un substrat comprenant une surface nanostructurée par le procédé ci-dessus.

Le domaine technique de l'invention peut être défini comme celui des diodes électroluminescentes organiques et plus particulièrement comme celui des diodes électroluminescentes organiques pourvues de nanostructurations en vue du renforcement de l'extraction lumineuse.

## ÉTAT DE LA TECHNIQUE ANTÉRIEURE

Les diodes électroluminescentes organiques OLED sont des diodes de nouvelle génération et constituent une technologie très prometteuse pour les afficheurs, tels que les écrans de télévisions et les écrans d'ordinateurs etc., et pour l'éclairage, grâce à leur faible consommation électrique.

De manière simplifiée, une diode électroluminescente organique comprend un substrat ou superstrat, une anode, une cathode et une ou des couche(s) organique(s) émettrice(s) prévue(s) entre l'anode et la cathode.

L'électrode en contact avec le substrat est généralement l'anode.

L'émission de lumière peut se faire du côté de l'anode ou bien du côté de la cathode.

L'électrode au travers de laquelle est réalisée l'émission de lumière est transparente à cette lumière.

Une OLED typique, dans laquelle l'émission de lumière est réalisée du côté de l'anode et du substrat comprend ainsi par exemple un substrat (que l'on peut alors appeler superstrat) de verre, une anode transparente par exemple en oxyde d'indium et d'étain (« ITO » ou « Indium Tin Oxide » en anglais), un empilement de couches organiques, et un miroir métallique faisant office de cathode.

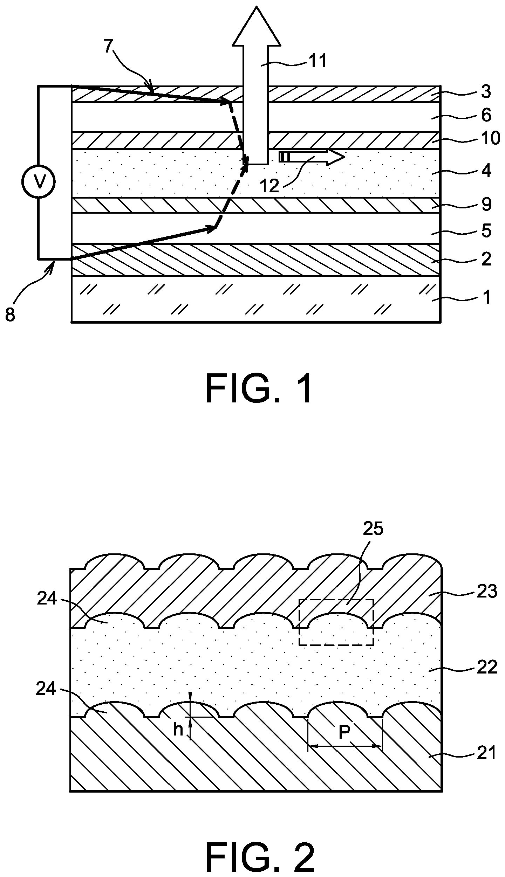

Sur la figure 1, on a représenté une autre OLED typique, dans laquelle l'émission de lumière est réalisée du côté de la cathode (3), à savoir du côté opposé à l'anode (2) et au substrat (1).

Cette diode comprend une ou plusieurs couche(s) mince(s) organique(s) émettrice(s) (4), par exemple trois couches minces organiques émettrices qui émettent respectivement dans le rouge, le vert et le bleu, qui sont entourées d'une part par une anode métallique (2) par exemple en aluminium ou en argent en contact avec le substrat (1) et d'autre part par une cathode transparente (3) constituée par exemple par de l'ITO ou par une couche mince d'argent.

Des couches diélectriques (5, 6) dopées P (5) ou N (6) aussi appelées couches d'injections d'électrons ou de trous sont généralement ajoutées entre les électrodes (2, 3) et les couches émettrices (4) afin d'améliorer l'injection des charges (électrons (7) et trous (8)) dans les couches émettrices organiques (4). Des couches de blocage d'électrons (9) et de blocage de trous (10) peuvent également être prévues.

Dans une OLED et notamment dans une OLED telle que celle représentée sur la figure 1, la lumière est émise dans les couches organiques dans toutes les directions.

Seulement une fraction des photons émis (20% environ) est réellement extraite de la diode (11) et 80% des photons et de la lumière sont donc perdus (12) dans les différents modes électromagnétiques relatifs aux couches métalliques et diélectriques.

Ces photons perdus, capturés par la structure sont éventuellement absorbés par effet Joule ou réémis sur les bords de la diode. Dans tous les cas, ces photons ne participent pas à la « lumière utile » de la diode.

Il est donc crucial d'améliorer l'extraction des photons perdus afin de les convertir en photons utiles pour d'augmenter le rendement optique.

Pour récupérer une partie de l'énergie perdue dans les plasmons ou les modes guidés, l'utilisation de réseaux périodiques a été proposée par exemple dans le document de W.L. BARNES, Journal of Lightwave technology, Vol. 17, No. 11, novembre 1999, pages 2170 - 2182 [1].

Ces réseaux peuvent être à une dimension, tels que des réseaux de lignes sensibles à une polarisation des émetteurs, ou à deux dimensions, tels que des réseaux carrés, triangulaires, des réseaux d'Archimède, ou des réseaux à géométrie plus complexe.

Sur la figure 2, on a représenté de manière simplifiée une OLED avec une anode (21), des couches organiques (22) et une cathode (23) qui sont pourvues de structurations périodiques (24) constituées par des motifs (25). Ces structurations périodiques ont une période P et une hauteur h.

Toutefois, une structuration mal maîtrisée peut entraîner une mise en court-circuit des deux électrodes, rendant l'empilement OLED inutilisable. De plus, la technologie permettant la structuration de l'OLED doit être nécessairement compatible avec les procédés de fabrication utilisés en microélectronique.

Les couches organiques émettrices des OLED sont très sensibles à l'air, à l'eau, et aux contraintes mécaniques.

L'expérience montre que les molécules émettrices de ces couches supportent mal tous les traitements intervenant « a posteriori » après la réalisation globale de la diode. C'est pourquoi la structuration de l'OLED est avantageusement imprimée, réalisée directement sur le substrat comme cela est décrit dans le document de D.K.GILFORD et D.G. HALL, Applied Physics Letters, Volume 81, Number 23, 2 décembre 2002, pages 4315 - 4317 [2] et dans le document de D.K.GILFORD et D.G. HALL, Applied Physics Letters, Volume 80, Number 20, 20 mai 2002, pages 3679 - 3681 [3]. Les dépôts de différentes couches métalliques et organiques de la diode étant conformant, le motif du réseau est reproduit sur l'ensemble de la diode.

Plus précisément, Le document de D.K.GILFORD et D.G. HALL, Applied physics Letters, Volume 81, Number 23, 2 décembre 2002, pages 4315 - 4317 [2], décrit la fabrication d'une OLED au cours de laquelle on dépose tout d'abord par centrifugation une couche de résine photosensible d'une épaisseur de 80 mm sur un substrat en silicium.

Cette couche de résine photosensible est ensuite impressionnée holographiquement et traitée pour former un réseau présentant un relief de surface avec une période de 550 nm et une amplitude pic-vallée d'environ 60 nm.

Sur la couche de résine photosensible, on dépose successivement cinq couches par dépôt sous vide à savoir une couche d'or, une couche de « NPB », une couche de tris (8-hydroquinoline) aluminium (Alq$_3$), une couche d'aluminium et une couche d'argent. La couche d'or forme l'anode du dispositif tandis que les couches d'Al/Ag forment la cathode.

Les couches déposées sur la résine, reproduisent le réseau sous-jacent de celle-ci, formant ainsi une ondulation périodique dans l'ensemble de la structure.

Dans le document de D.K.GILFORD et D.G. HALL, Applied Physics Letters, Volume 80, Number 20, 20 mai 2002, pages 3679 - 3681 [3], des lames de verre sont tout d'abord revêtues avec une couche mince (200 nm) de résine photosensible.

Les films de résine photosensible sont ensuite exposés à des franges d'interférences holographiques et révélés pour former un réseau présentant un relief de surface avec des périodes de 535 à 610 nm et des amplitudes pics-vallées d'environ 100 nm.

Les échantillons sont ensuite revêtus sous vide avec un film de tris(8-hydroquinoline) aluminium (Alq$_3$) d'une épaisseur de 200 nm, puis avec une couche d'argent d'une épaisseur de 50 nm.

Les couches déposées reproduisent le profil de la surface sous-jacente en résine et formant ainsi des ondulations dans l'ensemble de la structure.

Par ailleurs, le document de K. ISHIHARA, Applied Physics Letters 90, 111114 (2007) [4] décrit la fabrication d'une OLED avec une couche de cristaux photoniques bidimensionnels. Une ondulation périodique bidimensionnelle, à savoir un motif de treillis carré est formé sur un substrat en verre par une technique de lithographie par nano-impression directe (« direct NIL »).

Plus exactement, on commence par fabriquer un moule en silicium avec un motif en treillis carré de plots circulaires. Ce moule est placé dans une machine de lithographie par nano-impression et un substrat en verre est également placé sur le moule. On chauffe ensuite sous vide à une température supérieure à la température de transition vitreuse du substrat. Puis le motif de la couche de cristaux photoniques sur le moule est estampé sur la surface en verre par le piston de la machine de lithographie par nano-impression, et le substrat en verre est séparé du moule par refroidissement.

Sur le substrat en verre est déposée une anode transparente en Oxyde de Zinc et d'Indium (IZO) par pulvérisation cathodique, puis les autres couches de l'OLED sont formées par évaporation sous vide.

Le document US-B1-6,670,772 [5] a trait à la préparation d'un écran à OLED qui comprend un substrat, une couche de transistors à couches minces (« TFT ») formée sur le substrat, une couche isolante formée sur la couche de « TFT » et définissant une structure de réseau périodique, une première couche d'électrode formée sur la structure de réseau et conforme à la structure de réseau, une couche de matériau « OLED » formée sur la première couche d'électrode et conforme à la structure de réseau, et une seconde couche d'électrode formée sur la couche de matériau OLED et conforme à la structure de réseau.

Le document US-A1-2005/0088084 [6] décrit un dispositif sensiblement analogue à celui du document [5].

Le document US-A1-2001/0038102 [7] décrit un dispositif pour émettre de la lumière, telle qu'une OLED, qui comprend un substrat comportant deux éléments, à savoir une base transparente et une résine photopolymérisable.

La résine photopolymérisable est appliquée sur la surface supérieure de la base transparente.

Un moule d'estampage muni d'ondulations, nervures, permet de former une structuration dans la couche de résine.

Puis, on dépose successivement une première couche d'électrode, une couche active et une seconde couche d'électrode sur la couche de résine structurée.

Une structuration globale de la diode, telle que celle réalisée dans les documents précédemment cités permet le repliement des relations de dispersion des modes de plasmons de surface associées à toutes les interfaces métal-diélectrique comme cela est mentionné dans les documents [4] et [5]. Ces modes, évanescents par nature, deviennent radiatifs, entraînant un renforcement de l'extraction de lumière qui est indiqué dans les documents [4] à [7].

Si l'on s'intéresse maintenant aux procédés pour la réalisation d'un substrat nanostructuré, on note parmi les procédés mentionnés dans la littérature la nano-impression (« nano-imprint ») qui est notamment décrite dans les documents [4] et [7].

Cette technique de fabrication d'un substrat nanostructuré est compatible avec les procédés de fabrication utilisés en micro-électronique.

Cette technique permet également une production massive.

Cependant, comme cela est précisé dans l'article [4] et le brevet [7], la forme du motif constituant la structure est directement liée au moule utilisé et plusieurs moules sont donc nécessaires pour la réalisation de motifs différents et pour fabriquer une surface nanostructurée complexe.

Le document US-A1-2007/292986 décrit un procédé de fabrication d'un dispositif à semi-conducteurs dans lequel une paroi de séparation est préparée par un procédé de nanoimpression.

Le document WO-A-2005/089028 concerne un procédé de préparation d'un substrat transparent comprenant sur sa surface des motifs convexes hémisphériques dans lequel ces motifs sont formés sur la surface du substrat transparent en utilisant en tant que moule un substrat en aluminium comportant des motifs concaves.

Le document US-A-6,080,030 a trait à un procédé de préparation d'un dispositif électroluminescent comprenant un premier substrat, une couche d'électrode positive formée sur le premier substrat, un second substrat, une couche d'électrode négative formée sur le second substrat, et une couche active entre la couche d'électrode positive et la couche d'électrode négative. Dans ce procédé, une couche de résine est formée sur le premier substrat ou le second substrat et une structure convexe et concave est formée sur la couche de résine en pressant un moule ayant une structure convexe et concave contre la couche de résine.

La couche de résine peut être durcie sous l'action de lumière ou de chaleur appliquée notamment lors de l'étape de pressage.

Aucun des documents US-A1-2007/292986, WO-A-2005/089028, et US-A-6,080,030, ne divulgue ni ne suggère les étapes e) à g) du procédé revendiqué, et notamment l'étape e) au cours de laquelle la résine organique ou le matériau minéral est chauffé de manière à fluer, et la première nanostructuration de la couche de résine organique ou de matériau minéral est modifiée pour donner une seconde nanostructuration.

En outre, aussi bien dans le cas de la technique de nano-impression que dans le cas des autres techniques de préparation de substrats à surfaces nanostructurées, le contrôle de la forme du motif est crucial, et peut s'avérer critique, car cette forme a des répercussions sur toutes les couches ensuite déposées de manière conforme sur cette surface et donc sur le fonctionnement de l'ensemble du dispositif finalement fabriqué sur ce substrat tel qu'une OLED.

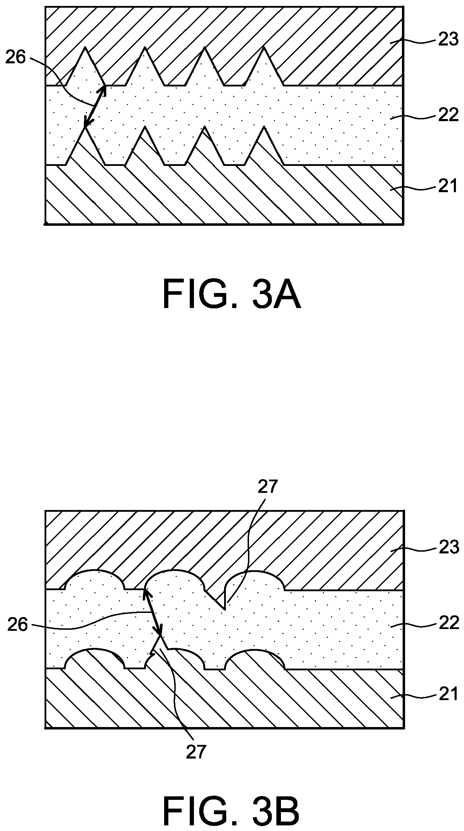

En effet, si un motif présente des arrêtes ou des pentes trop brutales, comme cela est représenté sur la figure 3A, des phénomènes de courts-circuits (26) entre les deux électrodes (21, 23) peuvent se produire, rendant l'OLED inutilisable.

De plus (voir figure 3B), comme tous les procédés de fabrication de substrats à surfaces nanostructurées, la nano-impression peut également donner localement des motifs avec des défauts (27) tels que pointes, aspérités bosses, ou une rugosité importante. La présence de ces défauts (27) locaux favorise l'apparition de courts-circuits (26).

Il existe donc au vu de ce qui précède, un besoin pour un procédé de fabrication d'un substrat comprenant une surface nanostructurée pour une diode électroluminescente organique OLED, qui permette de préparer de manière simple, fiable, reproductible et en un nombre limité d'étapes, une telle surface nanostructurée quelle que soit le type, la forme et la complexité de cette nanostructuration et des motifs qui peuvent la composer.

Il existe, en outre, un besoin pour un tel procédé qui permette de maîtriser, contrôler parfaitement, très précisément, la nanostructuration, et notamment la forme des motifs qui peuvent composer celle-ci.

Il existe encore un besoin pour un procédé qui permette de préparer un substrat avec une surface nanostructurée sans défauts, tels que pointes, aspérités, bosses ou autres, sans rugosité de surface, mais aussi sans arêtes, pentes, ou autres configurations géométriques trop brutales, et plus généralement sans formes susceptibles d'occasionner des courts circuits dans une diode OLED préparée en utilisant ce substrat nanostructuré.

Ce procédé doit, enfin, être totalement compatible avec les procédés de fabrication mis en oeuvre dans la micro-électronique et notamment avec les différents procédés utilisés dans la fabrication des OLEDs.

Le but de la présente invention est de fournir un procédé de fabrication d'un substrat comprenant une surface nanostructurée pour une diode électroluminescente organique OLED, qui réponde entre autres aux besoins et exigences énumérés plus haut.

Le but de la présente invention est aussi de fournir un procédé de fabrication d'un substrat comprenant une surface nanostructurée pour une diode électroluminescente organique OLED, qui ne présente pas les inconvénients, défauts, limitations et désavantages des procédés de l'art antérieur, et qui résolve les problèmes des procédés de l'art antérieur.

## EXPOSÉ DE L'INVENTION

Ce but, et d'autres encore, sont atteints, conformément à l'invention par un procédé de fabrication d'un substrat comprenant une surface nanostructurée pour une diode électroluminescente organique OLED, dans lequel on réalise les étapes successives suivantes :

a) on dépose une couche d'une résine organique ou d'un matériau minéral à faible température de fusion sur une surface plane d'un substrat ;
b) on chauffe la résine organique jusqu'à une température supérieure ou égale à sa température de transition vitreuse Tg ou à sa température de fusion, ou on chauffe le matériau minéral jusqu'à une température supérieure ou égale à sa température de fusion, et on imprime la couche de résine organique ou de matériau minéral liquide avec un moule présentant une nanostructuration, moyennant quoi la couche de résine organique ou de matériau minéral est munie d'une première nanostructuration conforme à la nanostructuration du moule ;

c) on abaisse la température de la résine organique ou du matériau minéral jusqu'à une température à laquelle il/elle est solide ;

d) on sépare le moule de la couche de résine organique ou de matériau minéral solidaire du substrat ;

caractérisé en ce que le procédé comprend, en outre, à l'issue de l'étape d), les étapes successives suivantes :

e) on chauffe la résine organique jusqu'à une température supérieure ou égale à sa température de transition vitreuse Tg ou à sa température de fusion, ou on chauffe le matériau minéral jusqu'à une température supérieure ou égale à sa température de fusion, et on maintient la résine organique ou le matériau minéral à cette température pendant un temps $t_R$ dit temps de recuit, moyennant quoi la résine organique ou le matériau minéral flue et la première nanostructuration de la couche de résine organique ou de matériau minéral est modifiée pour donner une seconde nanostructuration ;

f) on refroidit la résine organique ou le matériau minéral en-dessous de sa température de transition vitreuse ou de sa température de fusion pour la/le solidifier ;

g) éventuellement, on recuit la résine organique ou le matériau minéral solide.

Avantageusement, le substrat peut être en un matériau choisi parmi le verre, les céramiques transparentes, et les plastiques transparents.

Avantageusement, la résine organique peut avoir une température de transition vitreuse Tg ou une température de fusion supérieure à la ou aux température(s) de dépôt(s) ultérieur(s) d'une ou plusieurs autre(s) couche(s) sur la surface nanostructurée.

Avantageusement, le matériau minéral peut avoir une température de fusion supérieure à la ou aux température(s) de dépôt(s) ultérieur(s) d'une ou plusieurs autre(s) couche(s) sur la surface nanostructurée.

Avantageusement, la résine organique peut être choisie parmi les résines thermoplastiques et thermodurcissables, telles que les poly(styrène) (PS), les poly(méthacrylate de méthyle) (PMMA)s, les polyesters insaturés, les résines époxydes, les résines phénoliques, les polyimides, les polyamides, les polycarbonates, les polyoléfines tels que les polypropylènes, le POSS ou « polyhedral oligomeric silsesquioxane », et les mélanges de celles-ci.

Généralement, la couche de résine organique ou de matériau minéral peut avoir une épaisseur d'au moins 10 nm, de préférence de 10 nm à 10 μm.

La couche de résine organique peut être déposée par un procédé choisi parmi :

- le trempage-retrait (connu sous la terminologie anglaise « dip-coating ») ;

- l'enduction centrifuge ou revêtement par centrifugation (connue sous la terminologie anglaise « spin-coating ») ;

- l'enduction laminaire (connue sous la terminologie anglaise « laminar-flow-coating ») ;

- la pulvérisation (connue sous la terminologie anglaise « spray-coating ») ;

- l'épandage (connu sous la terminologie anglaise « soak coating ») ;

- l'enduction au rouleau (connue sous la terminologie « roll to roll process ») ;

- l'enduction au pinceau (connue sous la terminologie anglaise « painting coating ») ;

- la sérigraphie (connue sous la terminologie anglaise « screen printing ») ;

- le dépôt chimique en phase vapeur (« CVD ») ;

- le dépôt chimique en phase vapeur assisté par plasma (« PECVD » ou « PACVD »).

Les procédés préférés sont le revêtement par pulvérisation (« Spray coating ») ou le revêtement par centrifugation (« Spin coating »).

Avantageusement, la première nanostructuration peut être constituée par un réseau périodique, tel qu'un réseau à une dimension ou un réseau à deux dimensions.

La première nanostructuration peut être un réseau de lignes avec des motifs périodiques d'une période P et d'une hauteur h.

La première nanostructuration peut aussi être un réseau de plots.

Le temps de recuit $t_R$ peut être exprimé par la formule suivante dans le cas des réseaux de lignes. Cette formule est valable aussi bien pour le matériau minéral que pour la résine organique :

$$\frac{1}{t_R} = \frac{1}{\eta}\left(\frac{(2\pi)^4 \gamma}{3}\frac{e^3}{\lambda_n^4}\right)$$

où

- $\eta$ est la viscosité de la résine, du polymère, ou du matériau minéral,

- $\gamma$ est l'énergie de surface du polymère, ou du matériau minéral,

- e est l'épaisseur du film du polymère, ou du matériau minéral,

- $1/\lambda_n$ est la fréquence du motif spatial à faire fluer c'est-à-dire la fréquence du motif spatial de la première nanostructuration.

Cette formule est valable seulement pour les réseaux de lignes.

D'autres formules exprimant le temps de recuit peuvent être établies pour les autres nanostructurations. Cependant, pour les réseaux de plots, notamment, la formule analytique est beaucoup plus difficile à établir.

Avantageusement, le temps de recuit $t_R$ peut être de 0 à 1000 secondes, de préférence de 30 à 500 secondes, et de préférence encore de 100 à 200 secondes.

Avantageusement, la seconde nanostructuration est une nanostructuration exempte de défauts et/ou de formes susceptibles de provoquer des courts circuits dans une OLED.

Avantageusement, la surface de la seconde nanostructuration peut être décrite par une décomposition en série de Fourier, qui ne dépasse pas l'ordre 10, par exemple qui est d'ordre 1, 2 ou 5.

Avantageusement, la surface de la seconde nanostructuration est constituée par des motifs sinusoïdaux.

Le procédé selon l'invention peut être défini comme un procédé qui utilise la technique de la nano-impression couplée aux propriétés thermiques et mécaniques des résines organiques ou des matériaux minéraux à faible température de fusion afin de contrôler, maîtriser la nanostructuration et notamment la forme des motifs qui la compose. La nano-impression est une technique largement connue et bien maîtrisée qui met de même en oeuvre des équipements courants et éprouvés.

Le procédé selon l'invention comprend une succession spécifique d'étapes qui n'a jamais été décrite ni suggérée dans l'art antérieur, tel que représenté notamment par les documents cités plus haut.

En particulier, l'étape e) du procédé selon l'invention n'est ni décrite ni suggérée dans l'art antérieur.

Le procédé selon l'invention de fabrication d'un substrat comprenant une surface nanostructurée pour une diode électroluminescente organique OLED répond entre autres à l'ensemble des besoins énumérés plus haut et apporte une solution aux problèmes des procédés de l'art antérieur.

Le procédé selon l'invention est simple, fiable, facile à mettre en oeuvre et permet de préparer facilement, de manière contrôlée, reproductible des surfaces dont la nanostructuration, est parfaitement précisément, contrôlée, maîtrisée.

Le procédé selon l'invention ne met en oeuvre qu'un seul moule et ne nécessite pas plusieurs moules et opérations de moulage pour obtenir une surface nanostructurée même complexe.

Grâce au procédé selon l'invention, on obtient des substrats sans défauts locaux, sans rugosités de surface, et on contrôle parfaitement et simplement la nanostructuration et notamment la forme des motifs en agissant de manière très simple sur le temps de fluage, ou temps de recuit, de relaxation. On évite également la présence de motifs par exemple trop « aigus » ou avec une pente trop importante. En conséquence, la nanostructuration et notamment la forme des motifs des couches ultérieurement déposées sur la surface nanostructurée est également maîtrisée et ces couches ne présentent plus de défauts, rugosités ou géométries indésirables. La forme des motifs composant les réseaux d'extraction de la diode est parfaitement maîtrisée et une extraction renforcée mais aussi précisément modulée peut être obtenue. Les phénomènes de courts-circuits dans la diode préparée sur le substrat préparé par le procédé selon l'invention sont également évités.

L'invention concerne, en outre, un procédé de fabrication d'une diode électroluminescente organique OLED comprenant une étape de fabrication d'un substrat comprenant une surface nanostructurée, ladite étape étant réalisée par le procédé tel que décrit plus haut.

Ce procédé de fabrication d'une OLED présente de manière inhérente tous les avantages et les effets déjà mentionnés plus haut liés au procédé de préparation du substrat nanostructuré, et les avantages du procédé de fabrication d'une diode électroluminescente organique OLED selon l'invention découlent pour l'essentiel du procédé de préparation du substrat nanostructuré et ont été déjà largement exposés plus haut.

Avantageusement, dans le procédé de fabrication d'une OLED selon l'invention, on fabrique un substrat comprenant une surface nanostructurée, puis on dépose successivement sur la surface nanostructurée du substrat une couche de première électrode conforme à la surface nanostructurée, une ou plusieurs couche(s) organique(s) émettrice(s) conforme(s) à la surface nanostructurée, et une couche de seconde électrode conforme à la surface nanostructurée.

De préférence, la première électrode est une anode et la seconde électrode est une cathode.

Avantageusement, on peut déposer en outre sur le substrat une ou plusieurs autre(s) couche(s) conforme(s) à la surface nanostructurée, choisie(s) parmi une couche d'injection de trous, une couche de transport de trous, une couche d'injection d'électrons, une couche de transport d'électrons, une couche de blocage de trous, une couche de blocage d'électrons, et une couche de transistors à couches minces (« TFT »), deux ou plus parmi cette ou ces autre (s) couche(s), la ou les couche(s) organique(s) émettrice(s), la couche de première électrode et la couche de seconde électrode pouvant être confondues.

L'invention sera mieux comprise à la lecture de la description détaillée qui va suivre, faite à titre illustratif et non limitatif, en référence aux dessins joints dans lesquels :

## BRÈVE DESCRIPTION DES DESSINS

- La figure 1 est une vue schématique en coupe verticale d'une diode électroluminescente organique (« Organic Light Emitting Diode » ou « OLED » en anglais) ;
- La figure 2 est une vue schématique en coupe verticale d'une OLED avec des nanostructurations permettant l'extraction optique ;
- La figure 3A est une vue schématique en coupe verticale d'une OLED dont les couches organiques, l'anode et la cathode présentent des motifs avec une pente trop importante susceptibles de provoquer des courts-circuits ;
- La figure 3B est une vue schématique en coupe verticale d'une OLED dont les couches organiques, l'anode et la cathode présentent des motifs avec des défauts susceptibles de provoquer des courts-circuits.
- Les figures 4A à 4F sont des vues schématiques en coupe verticale qui illustrent les étapes successives de fabrication d'un substrat nanostructuré par le procédé selon l'invention mettant en oeuvre la technique de nano-impression.
- La figure 5 est un graphique qui représente l'évolution du profil expérimental d'un réseau de lignes denses avec une hauteur de 35 nm et une période de 500 nm imprimé dans un substrat de polystyrène pour différents temps de recuit, fluage à la température de 150°C, à savoir 0 seconde, 30 secondes, 100 secondes, 200 secondes, 500 secondes, et 1000 secondes.

En ordonnée est porté le profil de fluage, refusion (« reflowing profile ») en nm et en abscisse est portée la coordonnée x (en μm).

La courbe A (points □) correspond à un temps de fluage de 0 seconde.

La courbe B (points ♦ gris) correspond à un temps de fluage de 30 secondes.

La courbe C (points ▲ gris) correspond à un temps de fluage de 100 secondes.

La courbe D (points ×) correspond à un temps de fluage de 200 secondes.

La courbe E (points ■) correspond à un temps de fluage de 500 secondes.

La courbe F (points ○) correspond à un temps de fluage de 1000 secondes.

## EXPOSÉ DÉTAILLÉ DE MODES DE RÉALISATION PARTICULIERS

Le procédé de fabrication selon l'invention, d'un substrat comprenant une surface nanostructurée pour une diode électroluminescente organique OLED, comprend tout d'abord une étape au cours de laquelle on dépose une couche (41) de résine organique ou de matériau minéral à faible température de fusion sur une surface plane (43) d'un substrat (42).

Le substrat ou superstrat (42) selon la disposition de la diode électroluminescente organique peut être en tout matériau convenant pour la fabrication d'un substrat pour une OLED.

Le substrat peut être un substrat transparent, c'est-à-dire qui transmet la lumière, de préférence la lumière visible, ou bien un substrat opaque.

Il est bien sûr souhaitable que le substrat transmette la lumière, soit transparent, dans le cas où l'émission de lumière se fait au travers du substrat qui est alors généralement plutôt un « superstrat ».

Des exemples de matériaux transparents adéquats sont les verres, les céramiques transparentes et les plastiques transparents.

Dans le cas où l'émission de lumière se fait par l'électrode supérieure qui est généralement la cathode alors le substrat peut être aussi bien un substrat transmettant la lumière, qu'un substrat réfléchissant la lumière ou qu'un substrat absorbant la lumière.

Le substrat comporte au moins une surface plane (43) sur laquelle la résine organique (41) ou le matériau minéral à faible température de fusion est déposé.

Le substrat (42) peut ainsi avoir la forme d'une plaque ou plaquette comprenant deux surfaces planes parallèles, par exemple carrées rectangulaires ou encore circulaires.

Cette plaquette peut avoir une épaisseur de un ou quelques microns (2, 3, 5, 10 μm) à un ou quelques millimètres (2, 3, 5, 10 mm), de préférence de 1 μm à 3 mm, de préférence encore entre 10 μm et 2 mm, et une surface par exemple sous la forme d'un disque présentant un diamètre de 20 ou 30 cm.

La résine organique est avantageusement choisie parmi les résines organiques qui présentent une température de transition vitreuse Tg ou une température de fusion supérieure à la ou aux température(s) de dépôt(s) ultérieur(s) d'une ou plusieurs autre(s) couche(s) sur la surface nanostructurée en résine organique.

De même, le matériau minéral est avantageusement choisi parmi les matériaux qui présentent une température de fusion supérieure à la ou aux température(s) de dépôt(s) ultérieur(s) d'une ou plusieurs autre(s) couche(s) sur la surface nanostructurée en matériau minéral.

Par température de transition vitreuse ou température de fusion supérieure à la ou aux température(s) de dépôt, on entend généralement que la température de transition vitreuse ou la température de fusion de la résine organique ou du matériau minéral est supérieure d'au moins 5°C, et de préférence d'au moins 20°C à la température de dépôt la plus élevée utilisée pour le dépôt ultérieur de la ou des autres couches, sur la surface nanostructurée de la couche de résine organique ou de matériau minéral.

Cette ou ces autres couche(s) sont les couches aussi bien organiques que minérales ou métalliques qui entrent dans la constitution d'une diode électroluminescente organique et seront décrites en détail plus bas.

En choisissant une telle résine organique avec une telle température de transition vitreuse ou une telle température de fusion, ou un tel matériau minéral avec une telle température de fusion pour constituer la couche de résine organique, qui forme ensuite la surface nanostructurée, on évite que la nanostructuration soit déformée thermiquement au cours des étapes de dépôt de couches qui interviennent ensuite dans la fabrication de l'OLED, et on assure ainsi que la nanostructuration obtenue à l'issue du procédé selon l'invention de fabrication d'un substrat comprenant une surface nanostructurée, soit intégralement conservée après chaque étape de fabrication de l'OLED et à la fin du procédé complet de fabrication de l'OLED.

Rappelons que la température de transition vitreuse est la température à laquelle certains polymères passent d'un état solide dur vitreux à un état plastique. Au-dessus de cette température, on peut dire que ces résines, polymères sont fluides et peuvent donc s'écouler.

La résine peut être choisie parmi les résines thermoplastiques et les résines thermodurcissables.

Par résine, on entend également les mélanges de deux résines ou plus.

Des exemples de résines sont les polystyrènes (PS), les poly(méthacrylate de méthyle)s (PMMA), les polyesters insaturés, les résines époxydes, les résines phénoliques, les polyimides, les polyamides, les polycarbonates, les polyoléfines tels que les polypropylènes, le POSS ou « polyhedral oligomeric silsesquioxane » et les mélanges de celles-ci.

Dans le cas des résines, polymères, thermodurcissables, celui-ci peut être appliqué sous la forme d'une composition en deux parties comprenant les précurseurs de la résine avec par exemple d'une part une formulation et d'autre part un agent de réticulation, durcissement.

Le matériau minéral a une faible température de fusion.

Par faible température de fusion, on entend généralement que le matériau minéral a une température de fusion compatible avec les étapes ultérieures de fabrication des « OLEDS ». Généralement, cette température de fusion est inférieure à 200°C.

Le matériau minéral à faible température de fusion est généralement un métal ou un alliage métallique et il pourra être choisi par exemple parmi l'indium, et l'alliage à base d'antimoine, d'étain, de bismuth et de plomb qui fond à 136°C.

Par matériau minéral, on entend également les mélanges de deux matériaux ou plus.

La couche de résine organique (41) peut être déposée par une technique choisie parmi les techniques suivantes :

- le trempage-retrait (connu sous la terminologie anglaise « dip-coating ») ;

- l'enduction centrifuge (connue sous la terminologie anglaise « spin-coating ») ;

- l'enduction laminaire (connue sous la terminologie anglaise « laminar-flow-coating ») ;

- la pulvérisation (connue sous la terminologie anglaise « spray-coating ») ;

- l'épandage (connu sous la terminologie anglaise « soak coating ») ;

- l'enduction au rouleau (connue sous la terminologie « roll to roll process ») ;

- l'enduction au pinceau (connue sous la terminologie anglaise « painting coating ») ;

- la sérigraphie (connue sous la terminologie anglaise « screen printing »).

Toutes ces techniques peuvent être utilisées dans le procédé de l'invention surtout si on souhaite déposer des couches « épaisses », comme par exemple de l'ordre de 10 $\mu$m.

Dans ces techniques et notamment dans la technique d'enduction centrifuge, on met en oeuvre une solution de la résine, du polymère organique dans un solvant, généralement un solvant organique adéquate. A titre d'exemple, si le polymère est le poly(méthacrylate de méthyle) (PMMA), on pourra utiliser une solution de ce polymère dans le toluène.

La technique préférée est la technique d'enduction centrifuge ou bien la technique de pulvérisation. Outre les techniques en solution, on peut aussi utiliser pour le dépôt de la couche de résine le dépôt chimique en phase vapeur (« CVD »), ou le dépôt chimique en phase vapeur assisté par plasma (« PECVD « ou « PACVD »).

Pour le dépôt du matériau minéral, on peut utiliser le dépôt chimique en phase vapeur (« CVD »), ou le dépôt chimique en phase vapeur assisté par plasma (« PECVD « ou « PACVD »), ou une technique de croissance cristalline, comme par exemple l'épitaxie.

La couche déposée est de préférence une couche mince ou un film de résine ou de matériau minéral (41). Par couche mince (41), on entend généralement que la couche de résine a une épaisseur comprise entre quelques nanomètres et quelques centaines de nanomètres, de préférence de 10 à 500 nm.

L'épaisseur de la couche, de préférence mince, peut être mesurée et contrôlée, par exemple par des techniques ellipsométriques.

Une fois le dépôt de la couche, de préférence mince, de résine organique ou de matériau minéral réalisé, on chauffe (44) la résine ou le matériau minéral ou plus généralement le substrat qui les supporte, jusqu'à une température à laquelle ils sont dans un état liquide, fluide c'est-à-dire une température supérieure à la température de transition vitreuse Tg de la résine ou bien une température supérieure à la température de fusion de la résine ou du matériau minéral, et on imprime la couche, de préférence mince, de résine organique ou de matériau minéral liquide avec un moule (45) présentant une nanostructuration (46) prédéterminée, moyennant quoi la couche, de préférence mince, de résine organique ou de matériau minéral (41) est munie d'une première nanostructuration (47) conforme à la nanostructuration du moule.

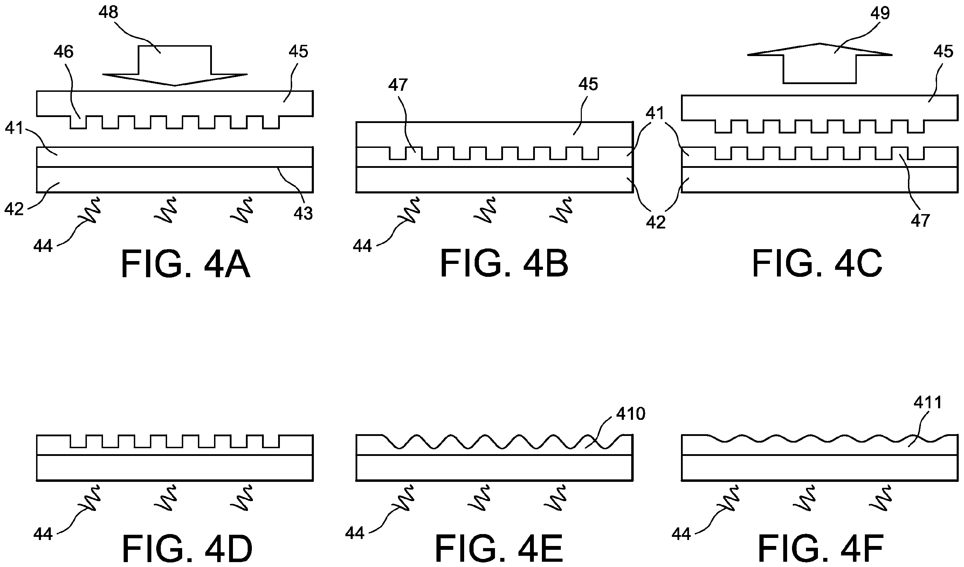

En d'autres termes, au cours de cette étape, un moule (45) pourvu d'une nanostructuration prédéterminée, définie, à savoir un moule dont la géométrie est connue est mis en contact avec la couche, de préférence mince, de résine organique ou de matériau minéral (41), puis on applique une certaine pression (48), par exemple de un à quelques centaines de mbar (2, 3, 5, 10) jusqu'à 10 ou 20 bar sur le moule (Figures 4A et 4B).

La résine ou le matériau minéral étant chauffés (44) à une température à laquelle ils sont liquides, fluides, à savoir une température supérieure à la température de transition vitreuse de la résine ou à une température supérieure à la température de fusion de la résine ou du matériau minéral, le moule s'imprime dans le film de polymère ou de matériau minéral fondu (41, Fig. 4B) qui se trouve ainsi pourvu d'une première nanostructuration conforme à la nanostructuration du moule.

Le moule peut être en un matériau tel que la silice ou le silicium ou le nickel ou un alliage « SiX ».

Une fois que la résine, polymère ou le matériau minéral a été mis en forme et a donc été pourvu d'une nanostructuration conforme à celle du moule, on abaisse la température de la résine ou du matériau minéral jusqu'à une température à laquelle elle est solide. Ainsi dans le cas d'une résine présentant une température de transition vitreuse, on abaisse la température de la résine jusqu'à une température inférieure à sa température de transition vitreuse, à laquelle elle est dans un état solide.

On sépare (49) ensuite le moule (45) de la couche, de préférence mince, de résine organique ou de matériau minéral solide (41) solidaire du substrat (42).

A ce stade du procédé, on a ainsi obtenu une couche, de préférence mince, de résine ou de matériau minéral, pourvue d'une première nanostructuration (47) conforme à la nanostructuration (46) dont était pourvu le moule.

On peut éventuellement procéder à ce stade à des étapes de caractérisation, contrôle, vérification, mesure de la surface nanostructurée obtenue.

Par exemple, on pourra réaliser des étapes de caractérisation morphologique fine de la surface nanostructurée afin de s'assurer de la conformité des motifs imprimés avec ceux du moule, et des techniques telles que la microscopie à force atomique répondent parfaitement à ce but.

La nanostructuration du moule, qui est conforme à la première nanostructuration de la résine organique ou du matériau minéral peut être constituée par un réseau périodique.

Ce réseau périodique peut être un réseau à une dimension ou un réseau à deux dimensions.

Un tel réseau à une dimension pourra par exemple être un réseau de lignes avec des motifs périodiques d'une période P et d'une hauteur h (voir la figure 2).

La période P peut être de 100 nm à quelques micromètres, de préférence de 100 nm à 1 $\mu$m, de préférence encore de 200 à 600 nm, et la hauteur h peut être d'au moins 5 nm à 100 nm, de préférence de 5 nm à 40 nm.

Si le réseau est un réseau à deux dimensions, il pourra être choisi notamment parmi les réseaux carrés, les réseaux triangulaires, rectangulaires, hexagonaux, et les réseaux plus complexes tels que les réseaux d'Archimède.

Le réseau peut aussi être un réseau de plots.

Il est à noter que la première nanostructuration présente généralement des motifs géométriques simples, non arrondis.

Par exemple, les lignes peuvent avoir une section transversale triangulaire (figure 3A), rectangulaire ou carrée (figures 4C, 4D).

La première nanostructuration peut comporter des défauts, tels que bosses, rugosités, décrochements, aspérités, pointes etc. et/ou des motifs avec des angles aigus, obtus, droits, par exemple des motifs avec une pente importante, des arêtes, qu'il est nécessaire d'éliminer ou d'atténuer, d'« adoucir », d'« arrondir » afin d'éviter l'apparition de courts circuits dans l'OLED.

Conformément à l'invention, on chauffe (44) (Figure 4D) la couche, de préférence mince, de résine ou de matériau minéral pourvue de la première nanostructuration (47), solidaire du substrat, jusqu'a une température supérieure ou égale à la température de transition vitreuse Tg de la résine supérieure ou égale à la température de fusion de la résine, ou supérieure ou égale à la température de fusion du matériau minéral, et on maintient la résine ou le matériau minéral à cette température pendant un temps $t_R$ dit temps de recuit, temps de fluage ou temps de relaxation.

La résine ou le matériau minéral qui compose la première nanostructuration et ses motifs se fluidifie, coule, flue (Figure 4D), et la première nanostructuration de la couche mince de résine et ses motifs sont ainsi modifiés pour donner une seconde nanostructuration (410) (Figure 4E) puis (411) (Figure 4F).

Cette étape peut être définie comme une étape de mise en forme finale de la surface de la couche de résine ou de matériau minéral qui utilise les propriétés de fluage de la résine ou du matériau minéral.

Cette étape peut être parfaitement modélisée, maîtrisée et permet un contrôle très fiable et très précis de la seconde nanostructuration, par exemple de la forme du motif qui compose le réseau périodique dans le cas où la seconde nanostructuration est constituée par un tel réseau périodique.

Ainsi, pour modéliser cette étape, la topographie du substrat pourvu de la première nanostructuration, est-elle exprimée sous la forme d'une décomposition spectrale.

Le temps de relaxation ou de recuit tR dépend de la fréquence spatiale du motif de résine ou du matériau minéral à faire fluer et peut être exprimé par la formule suivante dans le cas d'un réseau de lignes :

$$\frac{1}{t_R} = \frac{1}{\eta}\left(\frac{(2\pi)^4 \gamma}{3} \frac{e^3}{\lambda_n^4}\right)$$

où

- $\eta$ est la viscosité de la résine, du polymère, ou du matériau minéral,
- $\gamma$ est l'énergie de surface, de la résine ou du polymère, ou du matériau minéral,
- e est l'épaisseur du film, de la résine ou du polymère, ou du matériau minéral,
- $1/\lambda_n$ est la fréquence du motif spatial à faire fluer (c'est-à-dire la fréquence du motif spatial de la première nanostructuration).

Cette relation montre que plus la fréquence spatiale est grande, plus le temps de relaxation, recuit, fluage doit être grand.

La connaissance des caractéristiques physiques de la résine ou du matériau minéral, telles que la viscosité et l'énergie de surface permet notamment :

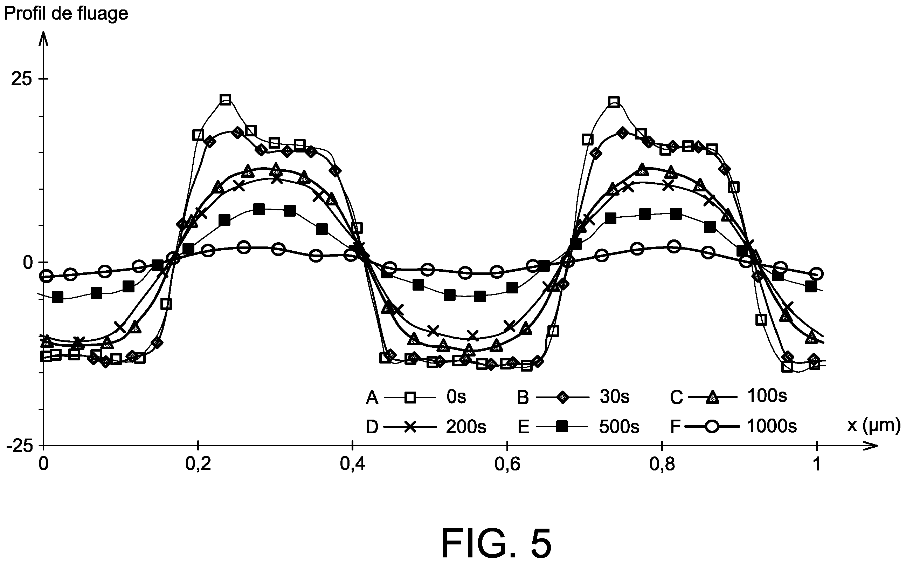

- d'éliminer la rugosité ou un défaut sur la structuration par un temps de fluage $t_R$ très court. A titre d'exemple comme cela est montré sur la figure 5, 30 secondes de recuit permettent d'éliminer les bosses présentes sur la gauche du motif initial de la première nanostructuration ;
- de contrôler finement la forme des motifs par des temps de recuit plus importants par exemple de 100 secondes à 1000 secondes comme cela est montré sur la figure 5.

Le procédé selon l'invention qui fait appel à une technique de nano-impression d'une résine ou du matériau minéral présentant des propriétés de fluage, met à profit ces propriétés pour créer des substrats nanostructurés dont la nanostructuration et en particulier la forme des motifs est parfaitement contrôlée, maîtrisée.

La nanostructuration et en particulier la forme des motifs de cette nanostructuration et leur fréquence, période, ayant une influence déterminante sur l'extraction optique d'une OLED comprenant le substrat nanostructuré préparé par le procédé selon l'invention, le temps de recuit, fluage permet également de contrôler parfaitement l'extraction optique de l'OLED et d'obtenir une extraction optique plus ou moins renforcée.

En effet, plus le temps de recuit est important plus l'amplitude des motifs de la première structuration est atténuée, réduite, et plus l'extraction optique se trouve diminuée.

Pour un renforcement de l'extraction dans le domaine du visible, la seconde nanostructuration pourra se présenter sous la forme d'un réseau de lignes avec une période de 100 à 600 nm, de préférence de 200 nm à 600 nm et avec une hauteur de 5 à 40 nm dans le cas où la première nanostructuration se présentait sous la forme d'un réseau de lignes avec une période de 100 à 600 nm, de préférence de 200 à 600 nm, et avec une hauteur de 5 à 40 nm.

Pour définir la seconde nanostructuration par rapport à la première nanostructuration dont elle est issue, on peut dire que la seconde nanostructuration, du fait du fluage de la résine organique ou du matériau minéral à faible point de fusion, présente une surface sur laquelle les motifs, formes de la première nanostructuration ont été arrondis, adoucis, atténués. La seconde nanostructuration ne présente plus les défauts tels que bosses, rugosités, décrochements, aspérités et pointes que pouvaient présenter la première nanostructuration. La seconde nanostructuration ne comporte plus de motifs avec des angles aigus, obtus, droits, d'arêtes, de motifs avec une pente importante, de motifs pointus : ces motifs sont adoucis arrondis, atténués de manière plus ou moins importante selon le temps de relaxation comme on l'a précisé plus haut. De manière simplifiée, on peut dire que la seconde structuration a une surface ne présentant que des courbes régulières, telles que des sinusoïdes en creux ou en relief.

Une autre définition de la seconde nanostructuration est qu'il s'agit d'une nanostructuration exempte de défauts et/ou de formes qui seraient susceptibles de provoquer des courts-circuits dans une OLED.

La surface ou la forme de la seconde nanostructuration peut être décrite par une décomposition en série de Fourier (décomposition en fonction sinusoïdale). La seconde nanostructuration correspond à une décomposition en série de Fourier limitée à l'ordre 10, par exemple à l'ordre 5, 2, ou 1. La limitation à l'ordre 10 veut dire que l'on aura des formes plus arrondies que si l'on avait une décomposition à l'ordre 50 par exemple.

Par contre, la surface ou la forme de la première nanostructuration peut être décrite par une décomposition en série de Fourier à un ordre supérieur à 10, par exemple à l'ordre 50. La décomposition à l'ordre 50 donne pour un réseau de lignes des motifs carrés ou rectangulaires (en créneaux) tandis qu'une décomposition à l'ordre 1 est une sinusoïde.

A l'issue de l'étape de recuit, fluage, de la résine ou du matériau minéral, on diminue la température de la résine ou du matériau minéral, généralement jusqu'à la température ambiante, généralement en ne les soumettant plus à un chauffage et on les maintient à la température ambiante pendant une durée suffisante pour solidifier la résine ou le matériau minéral.

Eventuellement, on procède à une étape de recuit (ne pas confondre avec le recuit, fluage déjà décrit plus haut) de la résine ou du matériau minéral solide à une température, qui est généralement une température supérieure à la température de fusion ou à la température de transition vitreuse, par exemple d'au moins 300°C pendant une durée par exemple de 30 secondes à 1 minute pour durcir la résine, par exemple thermodurcissable, c'est-à-dire pour renforcer la dureté de la résine afin qu'elle soit plus résistante car le recuit permet de réordonner les atomes.

On peut ensuite fabriquer une diode électroluminescente organique qui comprend en tant que substrat le substrat nanostructuré préparé par le procédé selon l'invention décrit ci-dessus.

Toute diode électroluminescente organique peut être fabriquée par le procédé selon l'invention, à la condition que le substrat soit préparé par le procédé selon l'invention tel que décrit plus haut.

Pour fabriquer cette diode électroluminescente organique, on dépose successivement et de manière conforme à la surface nanostructurée, les diverses couches constituant une OLED sur le substrat préparé par le procédé selon l'invention.

Il est à noter que toute description relative à la nature, au nombre, à la disposition, à la forme des couches de l'OLED donnée dans ce qui suit ne l'est qu'à titre indicatif, illustratif et non limitatif et que les mêmes avantages sont obtenus quels que soient le nombre, la nature, et la disposition de ces couches de l'OLED du moment que le substrat est un substrat nanostructuré préparé par le procédé selon l'invention.

L'OLED fabriquée par le procédé de fabrication d'une OLED selon l'invention peut être une des OLED décrites plus haut telle que celle décrite sur la Figure 1 ou une OLED telle que décrite dans le document [5] ou [6] ou bien encore dans le document [7]

De manière très générale, on peut déposer sur le substrat (ou superstrat) une anode, une cathode et des couches organiques émissives, les couches organiques émettrices de lumière étant déposées entre l'anode et la cathode. Tous ces dépôts sont bien sur, conformément à l'invention réalisés de manière conforme.

Lorsque l'émission est vue au travers de l'anode, l'anode doit être transparente ou essentiellement transparente.

Des matériaux d'anode transparents sont par exemple l'oxyde d'indium et d'étain (ITO), l'oxyde d'indium et de zinc (IZO) et l'oxyde d'étain, mais d'autres oxydes de métaux pourraient être utilisés, ou bien des sulfures ou séléniures de métaux.

Lorsque l'émission est vue au travers de la cathode, on peut utiliser pour l'anode tout matériau conducteur, qu'il soit transparent, opaque ou réfléchissant. On peut citer notamment l'aluminium, l'or, l'iridium, le molybdène, le platine et le palladium.

L'anode peut être déposée par exemple par évaporation, pulvérisation cathodique, dépôt chimique en phase vapeur ou par une technique électrochimique.

Selon l'invention, le dépôt de l'anode est réalisé de manière conforme à la surface nanostructurée du substrat préparé par le procédé selon l'invention.

Au-dessus de l'anode est généralement déposée une couche de transport de trous (encore appelés charges positives) qui contient au moins un composé de transport de trous tel qu'un composé d'amine tertiaire aromatique, un composé aromatique polycyclique, ou un polymère de transport de trous.

Entre la couche de transport de trous et l'anode, il peut être nécessaire de prévoir une couche d'injection de trous qui comprend par exemple des composés porphyriniques ou des amines aromatiques.

La couche d'injection de trous et la couche de transport de trous sont, selon l'invention, conformes à la nanostructuration de la surface du substrat.

La couche d'injection de trous et la couche de transport de trous peuvent être éventuellement confondues.

Au-dessus de la couche de transport de trous est(sont) déposée(s) une ou plusieurs couche(s) organique(s) émettrice(s).

L'OLED peut ne comprendre qu'une seule couche émettrice mais elle peut éventuellement comprendre plusieurs couches émettrices, par exemple deux ou trois couches émettrices superposées.

Dans le cas où trois couches émettrices sont présentes, ces couches pourront être des couches émettant respectivement dans le bleu, le vert et le rouge pour fournir de la lumière blanche (telle définie dans le diagramme standard de la CIE de 1931 ou 1976).

Les matériaux constituant ces couches émettrices sont connus de l'homme du métier.

Ces couches émettrices sont conformes à la nanostructuration du substrat et présentent donc les mêmes motifs de surface.

Cette ou ces couche (s) émettrice(s) sont généralement déposées par évaporation thermique.

Sur la ou les couche (s) émettrice(s), on dépose une couche de transport d'électrons puis une couche d'injection d'électrons qui sont bien entendu conformes à la nanostructuration du substrat. Ces deux couches peuvent être confondues et elles peuvent éventuellement être confondues avec la ou les couches émettrices.

Enfin, on dépose la cathode de l'OLED qui est également, selon l'invention, conforme à la surface nanostructurée du substrat.

Lorsque l'émission de lumière se produit seulement au travers de l'anode, la cathode peut être en tout matériau conducteur.

Si l'émission de lumière se produit au travers de la cathode, alors celle-ci doit être transparente à la lumière émise et peut être par exemple en oxyde d'indium et d'étain (ITO), ou en oxyde d'indium et de zinc (IZO).

La cathode est généralement déposée par évaporation, pulvérisation cathodique, ou dépôt chimique en phase vapeur.

D'autres couches, également conformes à la surface nanostructurée du substrat peuvent être prévues, telles qu'une couche de blocage de trous et une couche de blocage d'électrons.

L'invention va maintenant être décrite en référence aux exemples suivants, donnés à titre illustratif et non limitatif.

**EXEMPLES :**

Exemple 1 :

Dans cet exemple, on prépare un substrat par le procédé selon l'invention mettant en oeuvre une résine thermodurcissable, puis on prépare une diode électroluminescente organique sur ledit substrat par le procédé selon l'invention.

Le procédé de préparation du substrat comprend les étapes successives suivantes :

- dépôt (ou couchage) de la résine thermodurcissable Neb® 22 de Sumitomo Chemical Japan disponible dans le commerce, sur un « wafer » de silicium de 8 pouces ;
- compression de la résine à 110 °C pendant 5 minutes sous 300 mbar, moyennant quoi on obtient une première nanostructuration qui est un réseau de lignes ou un réseau de plots avec une période de 200 à 600 nm et des hauteurs de 5 à 40 nm ;
- fluage à 125 °C pendant 60 secondes ;
- solidification par exemple pendant 248 minutes à température ambiante, et recuit à 90 °C pendant 60 secondes ;

On obtient ainsi une seconde nanostructuration fluée et stable jusqu'à 200 °C qui est un réseau de lignes ou un réseau de plots avec une période de 200 à 600 nm et des hauteurs de 5 à 40 nm.

On dépose ensuite les couches « OLED » sur le substrat nanostructuré obtenu.

Exemple 2 :

Dans cet exemple, on prépare un substrat par le procédé selon l'invention mettant en oeuvre une résine polystyrène, puis on prépare une diode électroluminescente organique sur ledit substrat par le procédé selon l'invention.

Le procédé de préparation du substrat comprend les étapes successives suivantes :

- dépôt (ou couchage) de la résine polystyrène, sur un « wafer » de silicium de 8 pouces ;
- compression de la résine à 120°C pendant 5 minutes sous 300 mbar, moyennant quoi on obtient une première nanostructuration qui est un réseau de lignes avec une hauteur de 35 nm et une période de 500 nm ;
- on effectue un fluage à la température de 150°C pendant des durées variables ;
- et on réalise une solidification par exemple pendant 248 minutes à température ambiante, et un recuit à 90 °C pendant 60 secondes.

On observe ensuite les profils de recuit ou de fluage (« Reflowing profile ») obtenus pour les différentes durées de fluage. Les profils sont reproduits sur le graphique de la figure 5.

La courbe A (points □) montre le profil de la seconde nanostructuration pour un temps de fluage, de refusion de 0 seconde (la seconde nanostructuration présente alors un profil identique à celui de la première nanostructuration).

La courbe B (points ♦ gris) montre le profil de la seconde nanostructuration pour un temps de fluage de 30 secondes.

La courbe C (points ▲ gris) montre le profil de la seconde nanostructuration pour un temps de fluage de 100 secondes.

La courbe D (points ×) montre le profil de la seconde nanostructuration pour un temps de fluage de 200 secondes.

La courbe E (points ■) montre le profil de la seconde nanostructuration pour un temps de fluage de 500 secondes.

La courbe F (points ○) montre le profil de la seconde nanostructuration pour un temps de fluage de 1000 secondes.

Le graphique de la figure 5 montre qu'à 0 seconde, des défauts sont présents, à 30 secondes, des défauts tels que des décrochements sont toujours présents, mais à partir de 100 secondes, on a éliminé les défauts et on a un réseau sinusoïdal.

Pour la suite du procédé, on retient donc de préférence le substrat dans lequel la résine polystyrène a subi un fluage à 150°C pendant 100 secondes et dans lequel la seconde nanostructuration qui est stable jusqu'à 200°C, est un réseau sinusoïdal de lignes avec une hauteur de 25 nm et avec une période de 500 nm.

On dépose ensuite les couches « OLED » sur le substrat nanostructuré obtenu.

**Revendications**

1. Procédé de fabrication d'un substrat comprenant une surface nanostructurée pour une diode électroluminescente organique OLED, dans lequel on réalise les étapes successives suivantes :

   a) on dépose une couche (41) d'une résine organique ou d'un matériau minéral à faible température de fusion sur une surface plane (43) d'un substrat (42) ;
   b) on chauffe (44) la résine organique jusqu'à une température supérieure ou égale à sa température de transition vitreuse Tg ou à sa température de fusion, ou on chauffe le matériau minéral jusqu'à une température supérieure ou égale à sa température de fusion, et on imprime la couche de résine organique ou de matériau minéral liquide avec un moule (45) présentant une nanostructuration (46), moyennant quoi la couche (41) de résine organique ou de matériau minéral est munie d'une première nanostructuration (47) conforme à la nanostructuration du moule (45) ;
   c) on abaisse la température de la résine organique ou du matériau minéral jusqu'à une température à laquelle il/elle est solide ;
   d) on sépare (49) le moule (45) de la couche (41) de résine organique ou de matériau minéral solidaire du substrat (42) ;

   **caractérisé en ce que** le procédé comprend, en outre, à l'issue de l'étape d), les étapes successives suivantes :

   e) on chauffe la résine organique jusqu'à une température supérieure ou égale à sa température de transition vitreuse Tg ou à sa température de fusion, ou on chauffe le matériau minéral jusqu'à une température supérieure ou égale à sa température de fusion, et on maintient la résine organique ou le matériau minéral à cette température pendant un temps $t_R$ dit temps de recuit, moyennant quoi la résine organique ou le matériau minéral flue et la première nanostructuration (47) de la couche (41) de résine organique ou de matériau minéral est modifiée pour donner une seconde nanostructuration (410, 411) ;
   f) on refroidit la résine organique ou le matériau minéral en-dessous de sa température de transition vitreuse ou de sa température de fusion pour la/le solidifier ;
   g) éventuellement, on recuit la résine organique ou le matériau minéral solide.

2. Procédé selon la revendication 1 dans lequel le substrat (42) est en un matériau choisi parmi le verre, les céramiques transparentes, et les plastiques transparents.

3. Procédé selon la revendication 1 ou 2 dans lequel la résine organique a une température de transition vitreuse Tg ou une température de fusion supérieure à la ou aux température(s) de dépôt(s) ultérieur(s) d'une ou plusieurs autre(s) couche(s) sur la surface nanostructurée.

4. Procédé selon l'une quelconque des revendications précédentes dans lequel la résine est choisie parmi les résines thermoplastiques et les résines thermodurcissables telles que les poly(styrène)s (PS), les poly(méthacrylate de méthyle)s (PMMA)s, les polyesters insaturés, les résines époxydes, les résines phénoliques, les polyimides, les polyamides, les polycarbonates, les polyoléfines tels que les polypropylènes, le POSS ou « polyhedral oligomeric silsesquioxane » et les mélanges de celles-ci.

5. Procédé selon la revendication 1 ou 2, dans lequel le matériau minéral a une température de fusion supérieure à la ou aux température(s) de dépôt(s) ultérieur(s) d'une ou plusieurs autre(s) couche(s) sur la surface nanostructurée.

6. Procédé selon l'une quelconque des revendications 1, 2 et 5, dans lequel le matériau minéral a une température de fusion inférieure à 200°C.

7. Procédé selon l'une quelconque des revendications précédentes dans lequel la couche (41) de résine organique ou de matériau minéral a une épaisseur d'au moins 10 nm, de préférence de 10 nm à 10 $\mu$m.

8. Procédé selon l'une quelconque des revendications précédentes dans lequel la couche (41) de résine organique est déposée par un procédé choisi parmi le trempage-retrait; l'enduction centrifuge; l'enduction laminaire; la pulvérisation; l'épandage ; l'enduction au rouleau; l'enduction au pinceau; la sérigraphie ; le dépôt chimique en phase vapeur (« CVD ») ; le dépôt chimique en phase vapeur assisté par plasma (« PECVD » ou « PACVD »).

9. Procédé selon l'une quelconque des revendications précédentes dans lequel la couche (41) de matériau minéral est déposée par un procédé choisi parmi le dépôt chimique en phase vapeur (« CVD ») ; le dépôt chimique en phase vapeur assisté par plasma (« PECVD » ou « PACVD ») ; une technique de croissance cristalline comme l'épitaxie.

10. Procédé selon l'une quelconque des revendications précédentes dans lequel la première nanostructuration (47) est constituée par un réseau périodique, tel qu'un réseau à une dimension ou un réseau à deux dimensions.

11. Procédé selon la revendication 10 dans lequel la première nanostructuration (47) est un réseau de lignes avec des motifs périodiques d'une période P et d'une hauteur h, ou un réseau de plots.

12. Procédé selon la revendication 11, dans lequel le temps de recuit $t_R$ dans le cas d'un réseau de lignes est exprimé par la formule :

$$\frac{1}{t_R} = \frac{1}{\eta}\left(\frac{(2\pi)^4\,\gamma}{3}\,\frac{e^3}{\lambda_n^4}\right)$$

Où

- $\eta$ est la viscosité de la résine, ou du matériau minéral,
- $\gamma$ est l'énergie de surface, de la résine ou du matériau minéral,
- e est l'épaisseur du film, de la résine ou du matériau minéral,
- $1/\lambda_n$ est la fréquence du motif spatial à faire fluer c'est-à-dire la fréquence du motif spatial de la première nanostructuration.

13. Procédé selon l'une quelconque des revendications précédentes dans lequel le temps de recuit $t_R$ est de 0 à 1000 secondes, de préférence de 30 à 500 secondes, et de préférence encore de 100 à 200 secondes.

14. Procédé selon l'une quelconque des revendications précédentes dans lequel la seconde nanostructuration (410, 411) est une nanostructuration exempte de motifs avec une pente importante susceptibles de provoquer des courts circuits dans une OLED.

15. Procédé selon l'une quelconque des revendications précédentes dans lequel la surface de la seconde nanostructuration (410, 411) est constituée par une décomposition en série de Fourier, qui ne dépasse pas l'ordre 10, par exemple qui est d'ordre 1, 2 ou 5.

16. Procédé selon l'une quelconque des revendications précédentes dans lequel la surface de la seconde nanostructuration (410, 411) est constituée par des motifs sinusoïdaux.

17. Procédé de fabrication d'une diode électroluminescente organique OLED comprenant une étape de fabrication d'un substrat comprenant une surface nanostructurée dans lequel ladite étape est réalisée par le procédé selon l'une quelconque des revendications 1 à 16.

18. Procédé selon la revendication 17 dans lequel on fabrique un substrat comprenant une surface nanostructurée, puis on dépose successivement sur la surface nanostructurée du substrat une couche de première électrode conforme à la surface nanostructurée, une ou plusieurs couche(s) organique(s) émettrice(s) conforme(s) à la surface nanostructurée, et une couche de seconde électrode conforme à la surface nanostructurée.

19. Procédé selon la revendication 18 dans lequel la première électrode est une anode et la seconde électrode est une cathode.

20. Procédé selon l'une quelconque des revendications 18 et 19 dans lequel on dépose en outre sur le substrat une ou plusieurs autre(s) couche(s) conforme(s) à la surface nanostructurée, choisie(s) parmi une couche d'injection de trous, une couche de transport de trous, une couche d'injection d'électrons, une couche de transport d'électrons, une couche de blocage de trous, une couche de blocage d'électrons, une couche de transistors à couches minces (« TFT »), deux ou plus parmi cette ou ces autre(s) couche(s), la ou les couche (s) organique (s) émettrice (s), la couche de première électrode et la couche de seconde électrode pouvant être confondues.

**Patentansprüche**

1. Herstellungsverfahren eines Substrats mit einer nanostrukturierten Oberfläche für eine organische Elektrolumineszenz-Diode OLED, bei der man die folgenden sukzessiven Schritte durchführt :

a) man scheidet eine Schicht (41) aus einem organischen Harz oder aus einem mineralischen Material mit niedriger Schmelztemperatur auf einer planen Oberfläche (43) eines Substrats (42) ab ;
b) man erwärmt (44) das organische Harz bis auf eine Temperatur höher als oder gleich wie seine Glasübergangstemperatur Tg oder seine Schmelztemperatur, oder man erwärmt das mineralische Material bis auf eine Temperatur höher als oder gleich wie seine Schmelztemperatur, und man bedruckt die Schicht aus flüssigem organischem Harz oder aus flüssigem mineralischem Material mit einer Form (45), die eine Nanostrukturierung (46) aufweist, wodurch die Schicht (41) aus organischem Harz oder aus mineralischem Material mit einer ersten, der Nanostrukturierung der Form (45) entsprechenden Nanostrukturierung (47) versehen wird ;
c) man senkt die Temperatur des organischen Harzes oder des mineralischen Materials bis auf eine Temperatur ab, bei der es im festen Zustand ist.

d) man trennt (49) die Form (45) von der mit dem Substrat (42) verbundenen Schicht (41) aus organischem Harz oder mineralischem Material ;

**dadurch gekennzeichnet, dass** das Verfahren außerdem, am Ende des Schritts d), die folgenden sukzessiven Schritte umfasst:

e) man erwärmt das organische Harz bis auf eine Temperatur höher als oder gleich wie seine Glasübergangstemperatur Tg oder seine Schmelztemperatur, oder man erwärmt das mineralische Material bis auf eine Temperatur höher als oder gleich wie seine Schmelztemperatur, und man hält das organische Harz oder das mineralische Material auf dieser Temperatur während einer sogenannten Temperzeit $t_R$, wodurch das organische Harz oder das mineralische Material fließt und die erst Nanostrukturierung (47) der Schicht (41) aus organischem Harz oder aus mineralischem Material sich verändert, indem eine zweite Nanostrukturierung (410, 411) entsteht;

f) man kühlt das organische Harz oder das mineralische Material ab unter seine Glasübergangstemperatur oder seine Schmelztemperatur, so dass es erstarrt ;

g) eventuell tempert man das organische Harz oder das mineralische Material im erstarrten Zustand.

2. Verfahren nach Anspruch 1, bei dem das Substrat (42) aus einem Material ist, das ausgewählt wird unter Glas, den transparenten Keramiken, und den transparenten Kunststoffen.

3. Verfahren nach Anspruch 1 oder 2, bei dem das organische Harz eine Glasübergangstemperatur Tg oder eine Schmelztemperatur hat, die höher ist als die Temperatur(en) von einer (oder mehreren) späteren Abscheidung(en) von einer (oder mehreren) anderen bzw. weiteren Schicht(en) auf der nanostrukturierten Oberfläche.

4. Verfahren nach einem der vorhergehenden Ansprüche, bei dem das Harz ausgewählt wird unter den thermoplastischen Harzen und den hitzehärtbaren Harzen wie etwa die Polystyrole (PS), die Polymethylmethacrylate, die ungesättigten Polyester, die Expoxidharze, die Phenolharze, die Polyimide, die Polyamide, die Polykarbonate, die Polyolefine, wie etwa die Polypropylene, das POSS oder "polyhedral oligomeric silsesquioxane", und die Mischungen aus diesen.

5. Verfahren nach Anspruch 1 oder 2, bei dem das mineralische Material eine Schmelztemperatur hat, die höher ist als die Temperatur(en) der späteren Abscheidung(en) von einer (oder mehreren) anderen Schicht(en) auf der nanostrukturierten Oberfläche.

6. Verfahren nach einem der Ansprüche 1, 2 und 5, bei dem das mineralische Material eine Schmelztemperatur unter 200 °C hat.

7. Verfahren nach einem der vorhergehenden Ansprüche, bei dem die Schicht (41) aus organischem Harz oder aus mineralischem Material eine Dicke von mindestens 10 nm, vorzugsweise von 10 nm bis 10 μm hat.

8. Verfahren nach einem der vorhergehenden Ansprüche, bei dem die Schicht (41) aus organischem Harz durch ein Verfahren abgeschieden wird, das ausgewählt wird unter Tauchbeschichtung, Zentrifugalbeschichtung, Laminarbeschichtung, Sputterbeschichtung, Beschichtungen der Typen soak-coating, roll-to-roll process, painting coating, Siebdruck, CVD, PECVD oder PACVD.

9. Verfahren nach einem der vorhergehenden Ansprüche, bei dem die Schicht (41) aus mineralischem Material abgeschieden wird durch ein Verfahren, das ausgewählt wird unter CVD, PECVD oder PACVD ; einer Kristallwachstumstechnik wie etwa Epitaxie.

10. Verfahren nach einem der vorhergehenden Ansprüche, bei dem die erste Nanostrukturierung (47) durch ein periodisches Gitter wie etwa ein eindimensionales Gitter oder ein zweidimensionales Gitter gebildet wird.

11. Verfahren nach Anspruch 10, bei dem die erste Nanostrukturierung (47) ein Liniengitter mit periodischen Mustern einer Periode P und einer Höhe h, oder ein Punktgitter ist.

12. Verfahren nach Anspruch 11, bei dem die Temperzeit im Falle eines Liniengitters durch folgende Formel ausgedrückt wird :

$$\frac{1}{t_R} = \frac{1}{\eta}\left(\frac{(2\pi)^4 \gamma}{3} \frac{e^3}{\lambda_n^4}\right)$$

• $\eta$ ist die Viskosität des Harzes, oder des mineralischen Materials,

• $\gamma$ ist die Oberflächenenergie des Harzes oder des mineralischen Materials,

• $e$ ist die Dicke des Films, des Harzes oder des mineralischen Materials,

• $1/\lambda_n$ ist die Frequenz des fließend zu machenden räumlichen Musters, das heißt die Frequenz des räumlichen Musters der ersten Nanostrukturierung.

**13.** Verfahren nach einem der vorhergehenden Ansprüche, bei dem die Temperzeit $t_R$ 0 bis 1000 Sekunden, besser 30 bis 500 Sekunden, noch besser 100 bis 200 Sekunden beträgt.

**14.** Verfahren nach einem der vorhergehenden Ansprüche, bei dem die zweite Nanostrukturierung (410, 411) eine Nanostrukturierung ohne Muster mit einer starken Neigung ist, die in einer OLED Kurzschlüsse verursachen könnte.

**15.** Verfahren nach einem der vorhergehenden Ansprüche, bei dem die Oberfläche der zweiten Nanostrukturierung (410, 411) gebildet wird durch eine Fourierreihenzerlegung, die die 10. Ordnung nicht überschreitet, die zum Beispiel 1., 2. oder 5. Ordnung ist.

**16.** Verfahren nach einem der vorhergehenden Ansprüche, bei dem die Oberfläche der zweiten Nanostrukturierung (410, 411) gebildet wird durch sinusförmige Muster.

**17.** Herstellungsverfahren einer organischen elektrolumineszenten Diode OLED, umfassend einen Schritt zur Herstellung eines Substrats mit einer nanostrukturierten Oberfläche, bei dem der genannte Schritt durch ein Verfahren nach einem der Ansprüche 1 bis 16 realisiert wird.

**18.** Verfahren nach Anspruch 17, bei dem man ein Substrat mit einer nanostrukturierten Oberfläche herstellt, man dann auf der nanostrukturierten Oberfläche des Substrats nacheinander eine zu der nanostrukturierten Oberfläche konforme erste Elektrodenschicht, eine (oder mehrere) zu der nanostrukturierten Oberfläche konforme organische Emitterschicht(en), und eine zu der nanostrukturierten Oberfläche konforme zweite Elektrodenschicht abscheidet.

**19.** Verfahren nach Anspruch 18, bei dem die erste Elektrode eine Anode ist, und die zweite Elektrode eine Kathode ist.

**20.** Verfahren nach einem der Ansprüche 18 und 19, bei dem man außerdem auf dem Substrat eine (oder mehrere) andere, zu der (den) nanostrukturierten Oberfläche konforme Schicht(en) abscheidet, ausgewählt unter einer Löcherinjektionsschicht, einer Löchertransportschicht, einer Elektroneninjektionsschicht, einer Elektronentransportschicht, einer Löchersperrschicht, einer Elektronensperrschicht, einer Dünnschichttransistorenschicht ("TFT"), wobei zwei oder mehr von dieser (oder diesen) anderen Schicht(en), die organische(n) Emitterschicht(en), die Schicht der ersten Elektrode und die Schicht der zweiten Elektrode verschmolzen sein können.

**Claims**

**1.** Method for fabricating a substrate comprising a nanostructured surface for an organic light emitting diode OLED, in which the following successive steps are carried out:

a) a layer (41) of an organic resin or of a low melting point mineral material is deposited on a planar surface (43) of a substrate (42);
b) the organic resin is heated (44) to a temperature equal to or higher than its glass transition temperature Tg or its melting point, or the mineral material is heated to a temperature equal to or higher than its melting point, and the layer of liquid organic resin or mineral material is printed with a mould (45) having a nanostructuration (46), whereby the layer (41) of organic resin or mineral material is provided with a first nanostructuration (47) matching the nanostructuration of the mould (45);
c) the temperature of the organic resin or of the mineral material is lowered to a temperature at which it is solid;
d) the mould (45) is separated (49) from the layer (41) of organic resin or of mineral material joined to the substrate (42);

**characterized in that** the method further comprises, at the end of step d) the following successive steps:

e) the organic resin is heated to a temperature equal to or higher than its glass transition temperature Tg or its melting point, or the mineral material is heated to a temperature equal to or higher than its melting point, and the organic resin or the mineral material is maintained at this temperature for a time $t_R$ called annealing time, whereby the organic resin or the mineral material flows and the first nanostructuration (47) of the layer (41) of organic resin or of mineral material is modified to produce a second nanostructuration (410, 411);
f) the organic resin or the mineral material is cooled below its glass transition temperature or its melting point to solidify it;
g) optionally, the solid organic resin or the solid mineral material is annealed.

**2.** Method according to Claim 1, in which the substrate (42) is made of a material selected from glass, transparent ceramics, and transparent plastics.

**3.** Method according to either of Claims 1 and 2, in which the organic resin has a glass transition temperature Tg or a melting point higher than the subsequent deposition temperature (s) of one or more other layer (s) on the nanostructured surface.

**4.** Method according to any one of the preceding claims, in which the resin is selected from thermoplastic resins and thermosetting resins such as poly(styrene)s (PS), poly(methyl methacrylate)s (PMMA), unsaturated polyesters, epoxy resins, phenolic resins, polyimides, polyamides, polycarbonates, polyolefins such as polypropylenes, POSS or polyhedral oligomeric silsesquioxane and mixtures thereof.

**5.** Method according to either of Claims 1 and 2, in which the mineral material has a melting point higher than the subsequent deposition temperature(s) of one or more other layer(s) on the nanostructured surface.

**6.** Method according to any one of Claims 1, 2 and 5, in which the mineral material has a melting point lower than 200°C.

**7.** Method according to any one of the preceding claims, in which the layer (41) of organic resin or of mineral material has a thickness of at least 10 nm, preferably of 10 nm to 10 $\mu$m.

**8.** Method according to any one of the preceding claims, in which the layer (41) of organic resin is deposited by a method selected from dip-coating; spin-coating; laminar-flow coating; spray-coating; soak-coating; roll-to-roll coating; painting-coating; screen printing; chemical vapour deposition (CVD); plasma enhanced chemical vapour deposition (PECVD or PACVD).

**9.** Method according to any one of the preceding claims, in which the layer (41) of mineral material is deposited by a method selected from chemical vapour deposition (CVD); plasma enhanced chemical vapour deposition (PECVD or PACVD); a crystal growth technique such as epitaxy.

**10.** Method according to any one of the preceding claims, in which the first nanostructuration (47) consists of a periodic array, such as a one-dimensional or a two-dimensional array.

**11.** Method according to Claim 10, in which the first nanostructuration (47) is an array of lines with periodic patterns having a period P and a height h, or an array of bumps, dots.

**12.** Method according to Claim 11, in which the annealing time $t_R$ in the case of a linear array is expressed by the formula:

$$\frac{1}{t_R} = \frac{1}{\eta}\left(\frac{(2\pi)^4 \gamma}{3}\frac{e^3}{\lambda_n^4}\right)$$

where

- $\eta$ is the viscosity of the resin, or of the mineral material,
- $\gamma$ is the surface energy of the resin or of the mineral material,
- $e$ is the film thickness of the resin or of the mineral material,
- $1/\lambda_n$ is the frequency of the spatial pattern to be caused to flow, that is, the frequency of the spatial pattern of the first nanostructuration.

**13.** Method according to any one of the preceding claims, in which the annealing time $t_R$ is of 0 to 1000 seconds, preferably of 30 to 500 seconds, and even more preferably of 100 to 200 seconds.

**14.** Method according to any one of the preceding claims, in which the second nanostructuration (410, 411) is a nanostructuration free of patterns with a high slope liable to cause short-circuits in an OLED.

**15.** Method according to any one of the preceding claims, in which the surface of the second nanostructuration (410, 411) consists of a Fourier series decomposition, which does not exceed the 10th order, for example which has the order 1, 2 or 5.

**16.** Method according to any one of the preceding claims, in which the surface of the second nanostructuration (410, 411) consists of sinusoidal patterns.

**17.** Method for fabricating an organic light emitting diode comprising a step of fabricating a substrate comprising a nanostructured surface in which the said step is carried out by the method according to any one of Claims 1 to 16.

**18.** Method according to Claim 17, in which a substrate comprising a nanostructured surface is fabricated, and a first electrode layer matching the nanostructured surface, one or more emitting organic layer(s) matching the nanostructured surface, and a second electrode layer matching the nanostructured surface are then successively deposited on the nanostructured surface of the substrate.

**19.** Method according to Claim 18, in which the first electrode is an anode and the second electrode is a cathode.

**20.** Method according to either of Claims 18 and 19, in which one or more other layer(s) matching the nanostructured surface are further deposited on the substrate, selected from a hole injection layer, a hole transport layer, an electron injection layer, an electron transport layer, a hole blocking layer, an electron blocking layer, a thin film transistor (TFT) layer, two or more from these other layer(s), the emitting organic layer(s), the first electrode layer and the second electrode layer optionally being combined.

FIG. 1

FIG. 2

FIG. 3A

FIG. 3B

FIG. 4A

FIG. 4B

FIG. 4C

FIG. 4D

FIG. 4E

FIG. 4F

EP 2 192 635 B1

FIG. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6670772 B1
- US 20050088084 A1
- US 20010038102 A1
- US 2007292986 A1
- WO 2005089028 A
- US 6080030 A

**Littérature non-brevet citée dans la description**

- **W.L. BARNES.** *Journal of Lightwave technology,* Novembre 1999, vol. 17 (11), 2170-2182
- **D.K.GILFORD ; D.G. HALL.** *Applied Physics Letters,* 02 Décembre 2002, vol. 81 (23), 4315-4317
- **D.K.GILFORD ; D.G. HALL.** *Applied Physics Letters,* 20 Mai 2002, vol. 80 (20), 3679-3681
- **D.K.GILFORD ; D.G. HALL.** *Applied physics Letters,* 02 Décembre 2002, vol. 81 (23), 4315-4317
- **K. ISHIHARA.** *Applied Physics Letters,* 2007, vol. 90, 111114